# EUROPEAN PATENT APPLICATION

(11) **EP 4 050 456 A1**
(43) Date of publication of application: **31.08.2022**
(21) Application number: 22152004.2
(22) Date of filing: 18.01.2022
(51) Int. Cl.: G06F 1/18, H01L 25/10

(54) **ENHANCED INTEGRATED CIRCUIT COMPONENT POWER DELIVERY**

(30) Priority: 25.02.2021 US 202117185504
(71) Applicant: INTEL Corporation, Santa Clara, CA 95054 (US)
(72) Inventor: SMALLEY, Jeffory L., East Olympia, 98540 (US); HOLDEN, Thomas, Olympia, 98512 (US); WUNDERLICH, Russell, Livermore, 80536 (US); YAHYAEI-MOAYYED, Farzaneh, Paradise Valley, 85253 (US); PRABHUGOUD, Mohanraj, Hillsboro, 97124 (US); TAMDEM, Horthense Delphine, Portland, 97229 (US); BODDU, Vijaya, Pleasanton, 94566 (US); RADHAKRISHNAN, Kaladhar, Chandler, 85226 (US); HANNA, Timothy Glen, Tigard, 97224 (US); BHARATH, Krishna, Phoenix, 85008 (US); AMANOR-BOADU, Judy, GILBERT, 85295 (US); SCHMISSEUR, Mark A., Phoenix, 85048 (US); NEKKANTY, Srikant, Chandler, 85286 (US); ROSALES GALVAN, Luis E., PORTLAND, 97209 (US)
(74) Representative: 2SPL Patentanwälte PartG mbB

(57) **Abstract**

A processor module comprises an integrated circuit component attached to a power interposer. One or more voltage regulator modules attach to the power interposer via interconnect sockets and the power interposer routes regulated power signals generated by the voltage regulator modules to the integrated circuit component. Input power signals are provided to the voltage regulator from the system board via straight pins, a cable connector, or another type of connector. The integrated circuit component's I/O signals are routed through the power interposer to a system board via a socket located between the power interposer and the socket. Not having to route regulated power signals from a system board through a socket to an integrated circuit component can result in a system board with fewer layers, which can reduce overall system cost, as well as creating more area available in the remaining layers for I/O signal entry to the socket.

## Description

### BACKGROUND

Voltage regulators are used in computing systems to convert an input power signal (e.g., 12 V, 48 V) to one or more regulated power signals for use by integrated circuit components. Some existing voltage regulator modules plug into a connector that is attached to a system board near where the integrated circuit component is located. Other existing voltage regulators are integrated into integrated circuit components.

### BRIEF DESCRIPTION OF THE DRAWINGS

FIG. 1 illustrates an example processor module with attached voltage regulator modules to provide regulated power signals to an integrated circuit component.
FIG. 2 is a perspective view of an example voltage regulator module.
FIG. 3 is an exploded perspective view of an example processor module with attached example voltage regulator modules.
FIGS. 4A & 4B illustrate example signal breakouts from a socket with and without power entry, respectively.
FIG. 5 illustrates the example socket breakout of FIG. 4B along with the various printed circuit board layers used in various regions of the breakout for signal routing.
FIG. 6 is an example regulated power signal delivery method.
FIG. 7 is a block diagram of an example computing system in which the enhanced integrated circuit component power delivery technologies described herein can be utilized.

### DETAILED DESCRIPTION

With each processor generation, there is an increased demand for processor performance. Increased processor performance generally carries with it increased power consumption and an increase in the number of I/O signals needed to carry data to and from the processor. Processor area has generally not scaled with I/O signal count in successive processor generations, which has resulted in increased signal routing congestion around the processor. This increased congestion has driven up the number of layers in the system board to provide additional area to route I/O and power signals to the processor.

Voltage regulators, which provide regulated power signals to processors, have increased in size over processor generations to accommodate the increase in processor power consumption. The system board area occupied by voltage regulators has increased to the point that they may longer fit on one side of the system board and next-generation server systems may have to adopt dual-sided power signal entry with regulated power signals being provided to two sides of the processor. This would cause further I/O signal congestion and likely result in additional layers being added to the system board.

A first type of existing voltage regulator module plugs into a connector that is attached to a system board near where the integrated circuit component to which the voltage regulator module provides regulated power signals is located. The connector is typically an edge finger connector that holds the voltage regulator module orthogonal to the system board while aligning the module to be parallel with nearby dual in-line memory modules (DIMMs). This type of voltage regulator module can free up space on the system board and provide supplemental power to an integrated circuit component, but it does not reduce the number of regulated power signals to be routed to the integrated circuit component or the number of power signal connections on the integrated circuit component to which the regulated power signals are routed. Thus, this type of voltage regulator module provides only marginal improvement to power and I/O signal congestion. Further, voltage regulator modules of this type either decrease the amount of space available for DIMMs or decrease the amount of space available for an integrated circuit component heat sink, either of which can thermally limit system performance. With processor power consumption increasing over time, the thermal performance of processor heat sinks needs to increase as well, which is often realized in the form of larger heat sinks. Voltage regulator modules should not encroach on the space around DIMMs to accommodate a larger processor heat sink solution as the DIMMs have their own increasing thermal management demands due to I/O bandwidth increasing over time as well. Thus, the attractiveness of employing this first type of voltage regulator module in next-generation computing systems is likely to become less appealing.

A second type of existing voltage regulator is integrated into integrated circuit components. These voltage regulators can reduce integrated circuit processing yield and limits the voltage regulator options available to original design manufacturers (ODMs) and original equipment manufacturers (OEMs).

Disclosed herein are enhanced integrated circuit component power delivery technologies that relieve power and I/O signal routing congestion to integrated circuit components. Processor modules are disclosed that comprise an integrated circuit component attached to a power interposer. One or more voltage regulator modules are attached to the power interposer via a connector and are oriented substantially parallel to the integrated circuit component. The power interposer interfaces with a system board via a socket. By moving voltage regulator modules from the system board to a power interposer, the routing of regulated power signals from the voltage regulator module to the integrated circuit component does not interfere with the routing of I/O signals in the system board to the socket and signal routing congestion is reduced.

In the following description, specific details are set forth, but embodiments of the technologies described herein may be practiced without these specific details. Well-known circuits, structures, and techniques have not been shown in detail to avoid obscuring an understanding of this description. "An embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact. Terms modified by the word "substantially" include arrangements, orientations, spacings, or positions that vary slightly from the meaning of the unmodified term. For example, a voltage regulator module oriented substantially parallel to an integrated circuit component includes voltage regulator modules that are oriented within a few degrees of parallel with the integrated circuit component.

The description may use the phrases "in an embodiment," "in embodiments," "in some embodiments," and/or "in various embodiments," each of which may refer to one or more of the same or different embodiments. Furthermore, the terms "comprising," "including," "having," and the like, as used with respect to embodiments of the present disclosure, are synonymous.

As used herein, the term "integrated circuit component" refers to a packaged or unpacked integrated circuit product. A packaged integrated circuit component comprises one or more integrated circuits. In one example, a packaged integrated circuit component contains one or more processor units and a solder ball grid array (BGA) on an exterior surface of the package. In one example of an unpackaged integrated circuit component, a single monolithic integrated circuit die comprises solder bumps attached to contacts on the die. The solder bumps allow the die to be directly attached to a printed circuit board, such as a power interposer. An integrated circuit component can comprise one or more of any of the integrated circuits described or referenced herein, such as a processor unit (e.g., system-on-a-chip (SoC), processor cores, graphics processing unit (GPU), accelerator), I/O controller, chipset processor, memory, or network interface controller.

Reference is now made to the drawings, wherein similar or same numbers may be used to designate same or similar parts in different figures. The use of similar or same numbers in different figures does not mean all figures including similar or same numbers constitute a single or same embodiment. In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

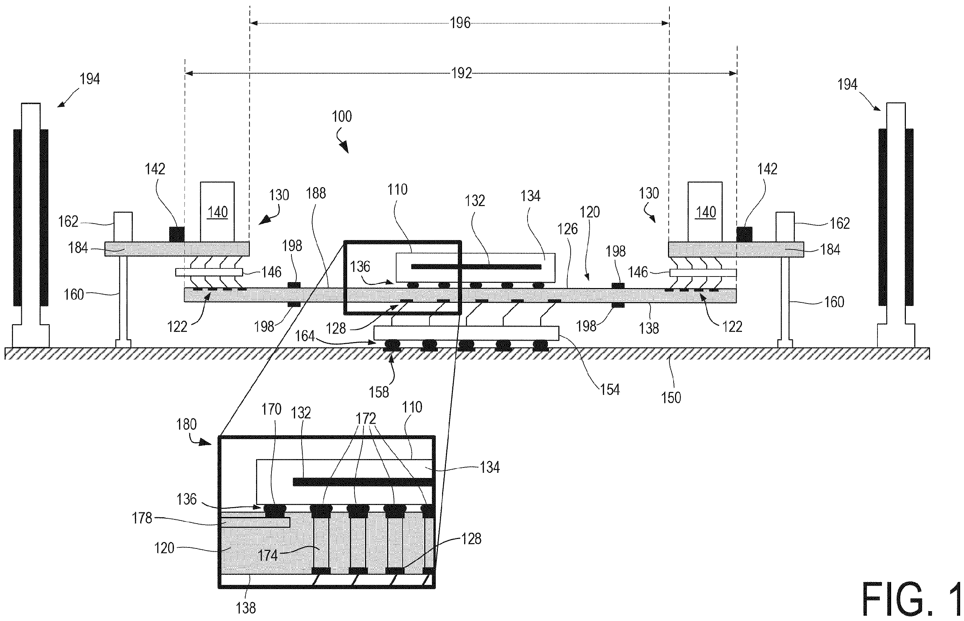

FIG. 1 illustrates an example processor module with attached voltage regulator modules to provide regulated power signals to an integrated circuit component. The processor module 100 comprises an integrated circuit component 110 and a power interposer 120. A pair of voltage regulator modules 130 are physically coupled to the processor module 100. The integrated circuit component 110 comprises an integrated circuit 132 in a package 134. The integrated circuit component 110 comprises a plurality of power signal connections 170 and a plurality of I/O signal connections 172, which are implemented as a solder ball grid array (BGA) 136. The power interposer 120 comprises a printed circuit board 188 that routes regulated power signals from the voltage regulator modules 130 to the integrated circuit component 110. The power interposer 120 connects to the voltage regulator modules 130 via pluralities of voltage regulator module connections 122 located on a first surface 126.

Each voltage regulator module 130 comprises a voltage regulator module printed circuit board 184 upon which a heat sink 140 and voltage regulator circuitry 142 are mounted. The voltage regulator boards 184 are oriented substantially parallel to the power interposer 120. Each voltage regulator module 130 is physically coupled to the power interposer 120 via an interconnect socket 146. In some embodiments, the interconnect socket 146 is a connector with a low z-height. DIMMs 194 are attached orthogonally to the system board 150 and are also orthogonal to the voltage regulator modules 130.

In some embodiments, the voltage regulator circuitry 142 comprises one or more power metal-oxide-semiconductor field-effect transistors (MOSFETs). The voltage regulator modules 130 generate one or more regulated power signals for use by the integrated circuit component 110 based on one or more input power signals. In some embodiments, the voltage regulator modules 130 provide a plurality of regulated voltages for use by various constituent components of the integrated circuit component 110. For example, the voltage regulator modules 130 can generate a regulated processing unit power signal for use by one or more processor cores, a regulated graphics processing unit (GPU) power signal for use by a GPU core, a regulated I/O power signal for use by I/O circuitry, a regulated memory power signal for use by one or more memories, and a regulated phase-locked loop (PLL) power signal for use by a PLL.

In some embodiments, the voltage regulator module 130 can comprise one or processor units described or referenced herein in addition to or instead of voltage regulator circuitry 142. For example, the module 130 can comprise an accelerator processor unit, graphics processing unit, general-purpose graphics processing unit instead of the voltage regulator circuitry 142. In such embodiments, instead of being referred to as a "voltage regulator module", the module 130 could be referred to as an accelerator module, a GPU module, a GPGPU module, or other appropriately-named module depending on the type of processor unit(s) located on the module 130. In some embodiments, different modules 130 can comprise different components. For example, a first module attached to an interposer that is in turn attached to an integrated circuit component could be a voltage regulator module and a second module attached to the interposer could be an accelerator module.

In some embodiments, the integrated circuit component 110 comprises one or more integrated circuit dies that work in conjunction with one more integrated circuit dies attached to one or more modules 130 to provide processor unit functionality. For example, the integrated circuit component 110 can comprise a plurality of processor cores and a module 130 can comprise an accelerator. In some embodiments, an embedded silicon bridge interconnection (e.g., Intel^{®} embedded multi-die interconnect bridge (EMIB)) can be used to connect integrated circuit dies included in the integrated circuit component to integrated circuit dies located on a module 130, to interconnect multiple integrated circuit dies located on the module 130, or to interconnect multiple integrated circuit dies located in the integrated circuit component 110.

Regulated power signals generated by the voltage regulator modules 130 are routed to the power signal connections 170 of the integrated circuit component 110 via internal conductive planes or traces of the power interposer printed circuit board that extend from the integrated circuit component 110 to the voltage regulator module connections 122, such as plane 178 illustrated in inset 180. Input power signals (e.g., 12V, 48V) are provided from the system board 150 to the voltage regulator modules 130 by pins 160 that connect to the voltage regulator modules 130 by connectors 162. In other embodiments, input power signals can be provided to the voltage regulator modules 130 in other manners, such as via cable connectors.

In some embodiments, the interconnect socket 146 is a dual compression socket that allows for the voltage regulator modules 130 to be removably attached to the processor module 100, allowing for the processor module 100 to be used with various voltage regulator module designs. In other embodiments, the voltage regulator modules 130 are removably attached to the power interposer 120 via other types of connectors. In some embodiments, the voltage regulator modules 130 are securely attached to the power interposer 120, such as via a ball grid array. The power interposer 120 and the voltage regulator modules 130 can be designed to accommodate the thermal management solution employed (e.g., heat sink, liquid-cooled cold plate) to keep the integrated circuit component 110 cooled. For example, a width 192 of the power interposer and/or a space 196 between voltage regulator module components can be designed to accommodate a heat sink attached to the integrated circuit component 110.

As shown in inset 180, a plurality of through-holes 174 (e.g., direct pass-through connections, board vias) in the power interposer 120 connect the I/O signal connections 172 to a plurality of socket connections 128 located on a second surface 138 of the power interposer 120, the second surface 138 facing in an opposite direction from the first surface 126 of the power interposer. The power interposer 120 is physically coupled to the system board 150 via a socket 154 that also electrically connects a plurality of system board connections 158 to the socket connections 128, thereby connecting the I/O signal connections 172 of the integrated circuit component 110 to the system board 150. The socket 154 is attached to the system board 150 via a ball grid array 164. The system board 150 routes the integrated circuit component 110 I/O signals from the system board connections to other components connected to the system board 150 via one or more system board traces. In some embodiments, the socket connections 128 comprise a land grid array or pin grid array and the socket 154 can be of a socket type that is compatible with the type of socket connection used. The processor module 100 comprises monolithic ceramic capacitors 198 that aid in limiting power signal droop in the regulated power signals.

By providing separate paths to the integrated circuit component 110 for the delivery of regulated power signals (via conductive planes in the power interposer 120) and I/O signals (via the socket 154 and power interposer through-holes 174), the aforementioned signal routing congestion problems are avoided or reduced. With I/O signals passing through the power interposer 120 and not having to compete with the entry of the regulated power signals to the integrated circuit component 110, the shapes of the printed circuit board planes or traces used to carry regulated power signals to the integrated circuit component are not restricted and can flood the area of the power interposer 120.

Although two voltage regulator modules 130 are illustrated in FIG. 1, in other embodiments, a single voltage regulator module can provide regulated power signals to the integrated circuit component 110. In still other embodiments, additional voltage regulator modules can provide additional regulated power signals to the integrated circuit component 110. In some embodiments, the processor module 100 can accommodate multiple voltage regulator modules in arrangements different than that illustrated in FIG. 1. For example, in a two-voltage regulator module embodiment, both voltage regulator modules could be located proximate to a same side of the integrated circuit component (e.g., both voltage regulator modules could be proximate to a top, left, right, or bottom side of the integrated circuit component (as viewed from above)) or proximate to adjacent sides of the integrated circuit component (e.g., one voltage regulator could be proximate to a top side of the integrated circuit component and the other voltage regulator module could be proximate to the left or right side of the integrated circuit component (as viewed from above)).

In some embodiments, the integrated circuit component 110 provides voltage regulator control signals to one or more of the voltage regulator modules 130 that allow for dynamic adjustment of one or more of the regulated power voltages generated by the voltage regulator modules 130. These voltage regulator control signals can be carried from the integrated circuit component 110 to the voltage regulator modules 130 via the power interposer 120. In some embodiments, an input power signal from which one of the voltage regulator modules 130 generates regulated power signals for use by the integrated circuit component 110 can be routed from the system board 150 through the socket 154 and the power interposer 120 to one of the voltage regulator modules 130. Providing an input power signal to one of the voltage regulator modules 130 through the socket 154 would utilize fewer socket pins than if the socket 154 were providing regulated power signals from the system board 150 to the integrated circuit component 110 as the current carried by the socket pins providing the input power signal the voltage regulator module 130 would be lower than that if the socket pins were providing regulated power signals to the integrated circuit component 110.

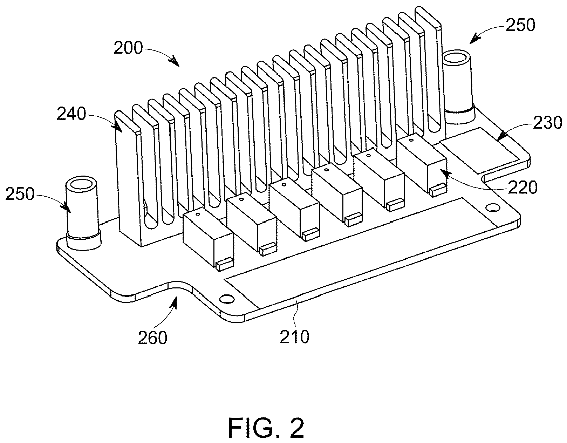

FIG. 2 is a perspective view of an example voltage regulator module. The voltage regulator module 200 comprises a printed circuit board 210, a plurality of power MOSFETs 220, a voltage regulator controller 230, a heat sink 240, and input power connectors 250. In some embodiments, the voltage regulator module 200 is configurable in that it can support different input power signal voltages and/or that the voltage levels of the regulated power signals generated by the voltage regulator module 200 are configurable. A configurable voltage regulator module can allow a single system board design to facilitate multiple system configurations. In some embodiments, the voltage regulator module 200 can be configured via voltage regulator control signals provided to the voltage regulator controller 230. The input power connectors 250 are press-fit connectors that connect to input power signal press-fit pins attached to a system board. As discussed previously, input power signals can be supplied to the voltage regulator module 200 by any of a variety of alternative approaches, such as via a cable connector or a power interposer.

The voltage regulator module 200 can be physically coupled to a power interposer using various attachment methods. For example, the voltage regulator module 200 can connect to an interconnection socket that connects to the power interposer (e.g., interconnect socket 146). The voltage regulator module 200 can connect to the interconnection socket via a land grid array or pin grid array located on a bottom surface 260 of the voltage regulator module 200. As discussed previously, in some embodiments, a dual compression socket can be used to connect the voltage regulator module 200 to a power interposer. In other embodiments, the voltage regulator module 200 can be soldered to a power interposer via a ball grid array located on the bottom surface 260.

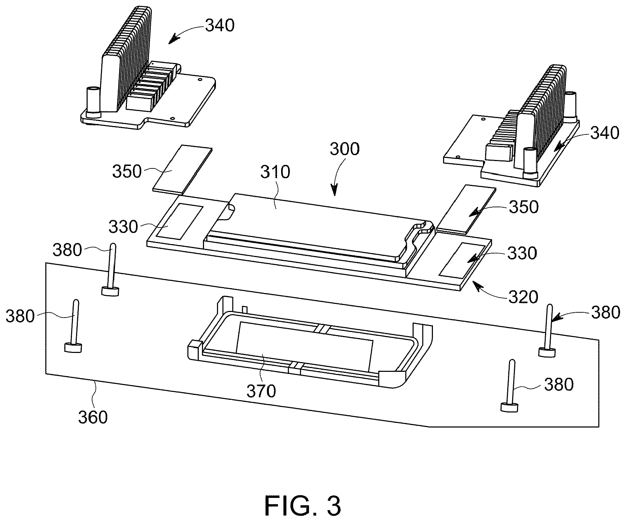

FIG. 3 is an exploded perspective view of an example processor module with attached example voltage regulator modules. The processor module 300 comprises an integrated circuit component 310 attached to a power interposer 320. The power interposer 320 comprises pluralities of voltage regulator module connections 330. The power interposer 320 is physically coupled to voltage regulator modules 340 via interconnect sockets 350 that connect to the voltage regulator module connections 330. The power interposer 320 connects to a system board 360 via a socket 370, which is illustrated in an LGA4677 form factor. Straight pins 380 supply input power signals from the system board 360 to the voltage regulator modules 340.

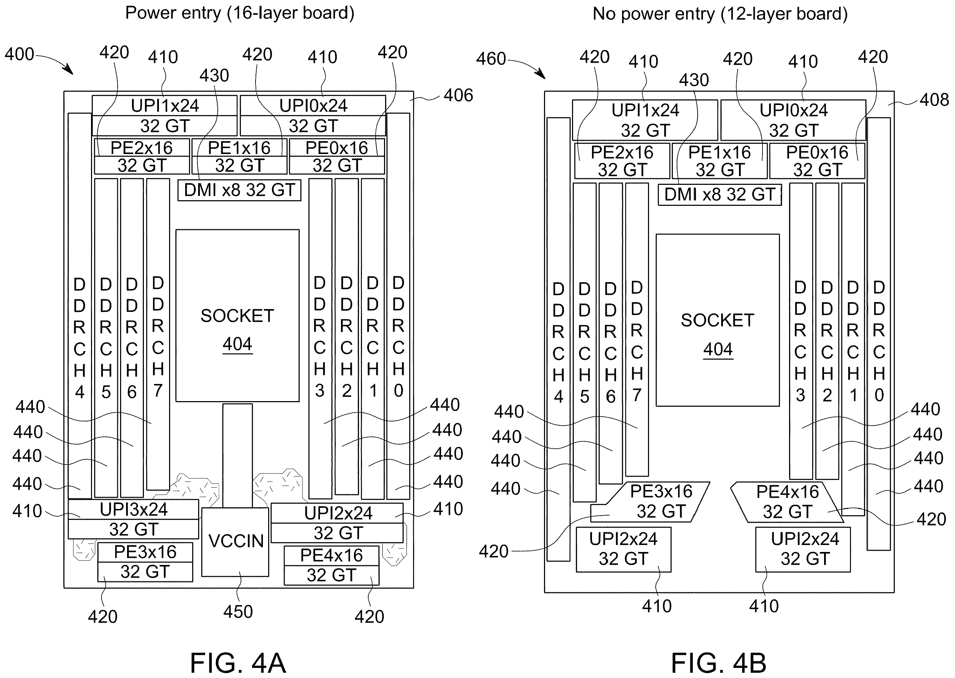

FIGS. 4A & 4B illustrate example signal breakouts (the routing of signals away from a socket) with and without power entry, respectively. FIG. 4A illustrates a breakout 400 around a socket 404 on a 16-layer system board 406 for four 24-lane Intel^{®} ultra-path interconnect (UPI) 32 (gigatransfers/second) GT/s links 410, five 16-lane peripheral component interconnect express (PCIe) GT/s links 420, one eight-lane direct media interface (DMI) 32 GT/s link 430, eight dual data rate (DDR) memory channels 440, and a VCCIN regulated power signal 450. FIG. 4B illustrates a socket breakout 460 around the socket 404 with a 12-layer system board 408 without entry of the VCCIN regulated power signal. The number of board layers can be reduced due to not having to route I/O signals around power traces in the system board. As can be seen, reducing the number of system board layers from 16 to 12 allows for I/O signals to be routed to the socket 404 with no less congestion due to not having to route a regulated power signal (VCCIN) to the socket 404 via the system board. The reduction in system board layer count enabled by offloading the routing of regulated power signals to a different component (e.g., a power interposer) results in cost savings in overall system designs.

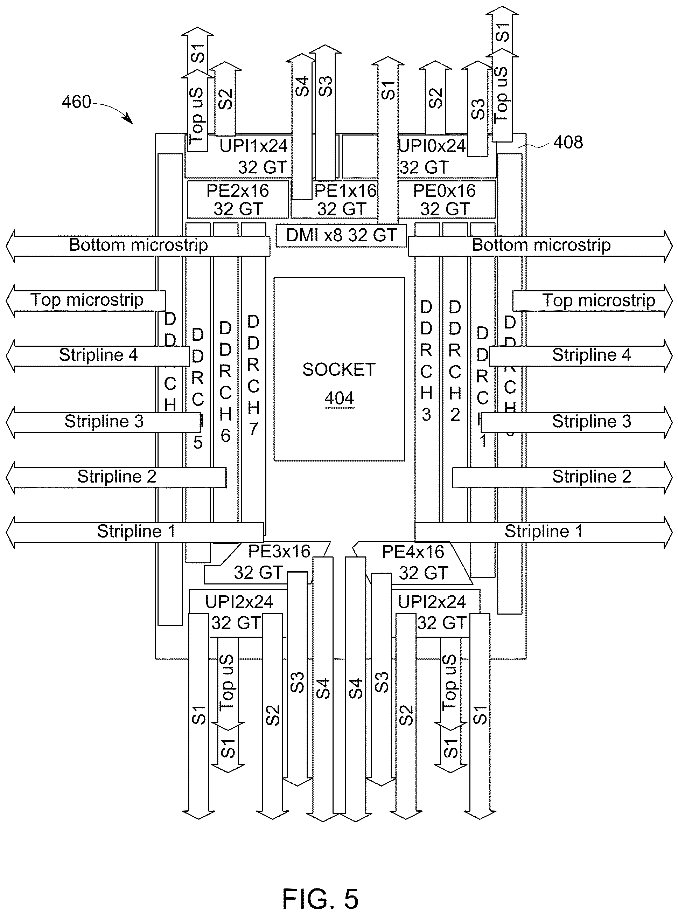

FIG. 5 illustrates the example socket breakout of FIG. 4B along with the various printed circuit board layers used in various regions of the I/O signal breakout. The 12-layer system board 408 comprises seven signal layers - a top microstrip layer (top uS), four stripline layers (S1, S2, S3, S4), and a bottom microstrip layer.

The disclosed processor modules with modular voltage regulator regulators have at least the following advantages. By moving the routing of regulated power signals from the system board to a power interposer, more system board area near where a socket attaches is available for I/O signal routing. This can reduce the routing length of I/O signal traces between memory modules (such as dual data rate (DDR) memory modules), which can increase performance. The length of UPI connections between processor sockets can also be reduced, which can further increase system performance. Further, freeing up socket pins previously used for the delivery of regulated power signals can increase the I/O features of an integrated circuit component. Moreover, voltage regulator modules can be located closer to integrated circuit components, which can reduce the power signal load and reduce the number of capacitors needed on the power interposer to control power signal droop. Furthermore, the technologies described herein enable the placing of more voltage regulator phases in the voltage regulator modules, which allows the voltage regulators to support higher levels of integrated circuit component power consumption. Moreover, by orienting the voltage regulator modules parallel to an integrated circuit component, the voltage regulator modules do not interfere with the thermal performance of adjacently located DIMMs or the integrated circuit component heat sink. Furthermore, the modular voltage regulator module approach allows for OEM/ODM flexibility in system design. Configurable voltage regulator modules allow for a single system board to be used with various processor modules and different voltage regulator modules can be used with a particular system board or a particular integrated circuit component.

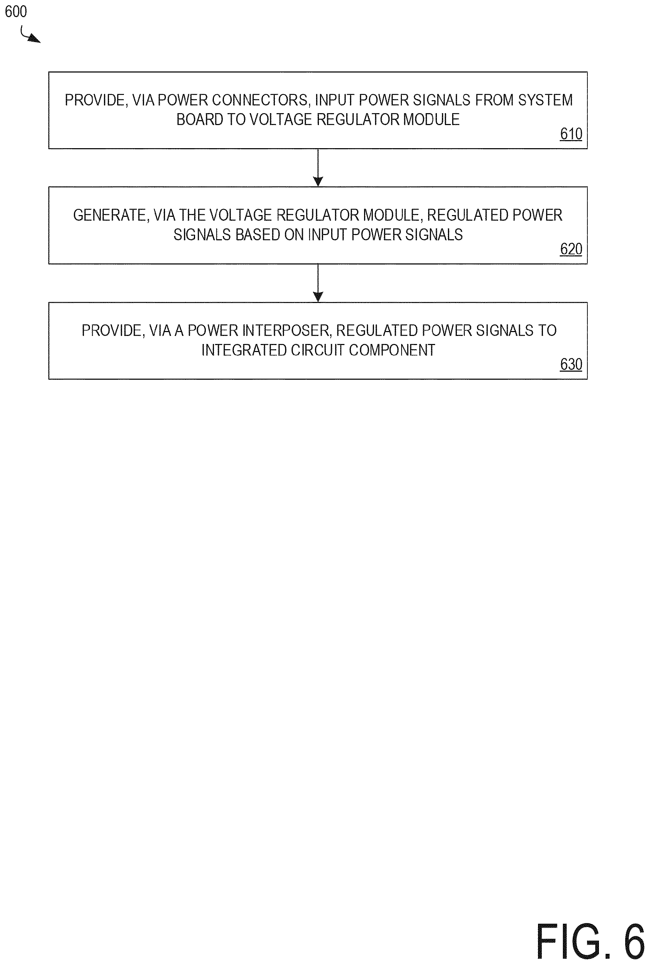

FIG. 6 is an example regulated power signal delivery method. The method 600 can be performed by, for example, a server system. At 610, one or more power connectors provide one or more input power signals from a system board to a voltage regulator module. At 620, the voltage regulator module generates one or more regulated power signals based on the one or more input power signals. At 630, a power interposer provides the regulated one or more power signals to an integrated circuit component. In other embodiments, the method 600 can comprise additional elements. For example, the method 600 can further comprise providing a plurality of I/O signals from the system board to the integrated circuit component via a socket and the power interposer.

The technologies, techniques and embodiments described herein can be performed by any of a variety of computing systems, such as desktop computers, servers, workstations, stationary gaming consoles, set-top boxes, smart televisions, rack-level computing solutions (e.g., blades, trays, sleds)), and embedded computing systems (e.g., computing systems that are part of a vehicle, smart home appliance, consumer electronics product or equipment, manufacturing equipment). As used herein, the term "computing system" includes computing devices and includes systems comprising multiple discrete physical components. In some embodiments, the computing systems are located in a data center, such as an enterprise data center (e.g., a data center owned and operated by a company and typically located on company premises), managed services data center (e.g., a data center managed by a third party on behalf of a company), a colocated data center (e.g., a data center in which data center infrastructure is provided by the data center host and a company provides and manages their own data center components (servers, etc.)), cloud data center (e.g., a data center operated by a cloud services provider that host companies applications and data), and an edge data center (e.g., a data center, typically having a smaller footprint than other data center types, located close to the geographic area that it serves).

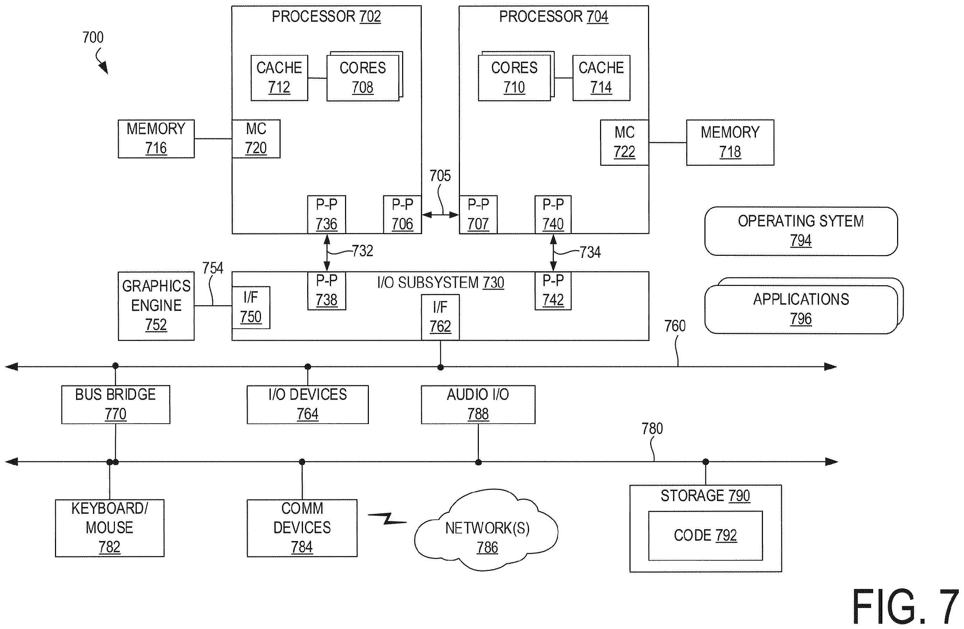

Generally, components shown in FIG. 7 can communicate with other shown components, although not all connections are shown, for ease of illustration. The computing system 700 is a multiprocessor system comprising a first processor unit 702 and a second processor unit 704 comprising point-to-point (P-P) interconnects. A point-to-point (P-P) interface 706 of the processor unit 702 is coupled to a point-to-point interface 707 of the processor unit 704 via a point-to-point interconnection 705. It is to be understood that any or all of the point-to-point interconnects illustrated in FIG. 7 can be alternatively implemented as a multi-drop bus, and that any or all buses illustrated in FIG. 7 could be replaced by point-to-point interconnects.

The processor units 702 and 704 comprise multiple processor cores. Processor unit 702 comprises processor cores 708 and processor unit 704 comprises processor cores 710. Processor cores 708 and 710 can execute computer-executable instructions in a manner similar to that discussed below in connection with FIG. 8, or other manners.

Processor units 702 and 704 further comprise cache memories 712 and 714, respectively. The cache memories 712 and 714 can store data (e.g., instructions) utilized by one or more components of the processor units 702 and 704, such as the processor cores 708 and 710. The cache memories 712 and 714 can be part of a memory hierarchy for the computing system 700. For example, the cache memories 712 can locally store data that is also stored in a memory 716 to allow for faster access to the data by the processor unit 702. In some embodiments, the cache memories 712 and 714 can comprise multiple cache levels, such as level 1 (L1), level 2 (L2), level 3 (L3), level 4 (L4), and/or other caches or cache levels, such as a last level cache (LLC). Some of these cache memories (e.g., L2, L3, L4, LLC) can be shared among multiple cores in a processor unit. One or more of the higher levels of cache levels (the smaller and faster caches) in the memory hierarchy can be located on the same integrated circuit die as a processor core and one or more of the lower cache levels (the larger and slower caches) can be located on an integrated circuit dies that are physically separate from the processor core integrated circuit dies.

Although the computing system 700 is shown with two processor units, the computing system 700 can comprise any number of processor units. Further, a processor unit can comprise any number of processor cores. A processor unit can take various forms such as a central processing unit (CPU), a graphics processing unit (GPU), general-purpose GPU (GPGPU), accelerated processing unit (APU), field-programmable gate array (FPGA), neural network processing unit (NPU), data processor unit (DPU), accelerator (e.g., graphics accelerator, digital signal processor (DSP), compression accelerator, artificial intelligence (AI) accelerator), controller, or other types of processing units. As such, the processor unit can be referred to as an XPU (or xPU). Further, a processor unit can comprise one or more of these various types of processing units. In some embodiments, the computing system comprises one processor unit with multiple cores, and in other embodiments, the computing system comprises a single processor unit with a single core. As used herein, the terms "processor unit" and "processing unit" can refer to any processor, processor core, component, module, engine, circuitry, or any other processing element described or referenced herein.

In some embodiments, the computing system 700 can comprise one or more processor units that are heterogeneous or asymmetric to another processor unit in the computing system. There can be a variety of differences between the processing units in a system in terms of a spectrum of metrics of merit including architectural, microarchitectural, thermal, power consumption characteristics, and the like. These differences can effectively manifest themselves as asymmetry and heterogeneity among the processor units in a system.

The processor units 702 and 704 can be located in a single integrated circuit component (such as a multi-chip package (MCP) or multi-chip module (MCM)) or they can be located in separate integrated circuit components. An integrated circuit component comprising one or more processor units can comprise additional components, such as embedded DRAM, stacked high bandwidth memory (HBM), shared cache memories (e.g., L3, L4, LLC), input/output (I/O) controllers, or memory controllers. Any of the additional components can be located on the same integrated circuit die as a processor unit, or on one or more integrated circuit dies separate from the integrated circuit dies comprising the processor units. In some embodiments, these separate integrated circuit dies can be referred to as "chiplets". In some embodiments where there is heterogeneity or asymmetry among processor units in a computing system, the heterogeneity or asymmetric can be among processor units located in the same integrated circuit component. In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Processor units 702 and 704 further comprise memory controller logic (MC) 720 and 722. As shown in FIG. 7, MCs 720 and 722 control memories 716 and 718 coupled to the processor units 702 and 704, respectively. The memories 716 and 718 can comprise various types of volatile memory (e.g., dynamic random-access memory (DRAM), static random-access memory (SRAM)) and/or non-volatile memory (e.g., flash memory, chalcogenide-based phase-change non-volatile memories), and comprise one or more layers of the memory hierarchy of the computing system. While MCs 720 and 722 are illustrated as being integrated into the processor units 702 and 704, in alternative embodiments, the MCs can be external to a processor unit.

Processor units 702 and 704 are coupled to an Input/Output (I/O) subsystem 730 via point-to-point interconnections 732 and 734. The point-to-point interconnection 732 connects a point-to-point interface 736 of the processor unit 702 with a point-to-point interface 738 of the I/O subsystem 730, and the point-to-point interconnection 734 connects a point-to-point interface 740 of the processor unit 704 with a point-to-point interface 742 of the I/O subsystem 730. Input/Output subsystem 730 further includes an interface 750 to couple the I/O subsystem 730 to a graphics engine 752. The I/O subsystem 730 and the graphics engine 752 are coupled via a bus 754.

The Input/Output subsystem 730 is further coupled to a first bus 760 via an interface 762. The first bus 760 can be a Peripheral Component Interconnect Express (PCIe) bus or any other type of bus. Various I/O devices 764 can be coupled to the first bus 760. A bus bridge 770 can couple the first bus 760 to a second bus 780. In some embodiments, the second bus 780 can be a low pin count (LPC) bus. Various devices can be coupled to the second bus 780 including, for example, a keyboard/mouse 782, audio I/O devices 788, and a storage device 790, such as a hard disk drive, solid-state drive, or another storage device for storing computer-executable instructions (code) 792 or data. The code 792 can comprise computer-executable instructions for performing methods described herein. Additional components that can be coupled to the second bus 780 include communication device(s) 784, which can provide for communication between the computing system 700 and one or more wired or wireless networks 786 (e.g. Wi-Fi, cellular, or satellite networks) via one or more wired or wireless communication links (e.g., wire, cable, Ethernet connection, radiofrequency (RF) channel, infrared channel, Wi-Fi channel) using one or more communication standards (e.g., IEEE 702.11 standard and its supplements).

In embodiments where the communication devices 784 support wireless communication, the communication devices 784 can comprise wireless communication components coupled to one or more antennas to support communication between the computing system 700 and external devices. The wireless communication components can support various wireless communication protocols and technologies such as Near Field Communication (NFC), IEEE 1002.11 (Wi-Fi) variants, WiMax, Bluetooth, Zigbee, 4G Long Term Evolution (LTE), Code Division Multiplexing Access (CDMA), Universal Mobile Telecommunication System (UMTS) and Global System for Mobile Telecommunication (GSM), and 5G broadband cellular technologies. In addition, the wireless modems can support communication with one or more cellular networks for data and voice communications within a single cellular network, between cellular networks, or between the computing system and a public switched telephone network (PSTN).

The system 700 can comprise removable memory such as flash memory cards (e.g., SD (Secure Digital) cards), memory sticks, Subscriber Identity Module (SIM) cards). The memory in system 700 (including caches 712 and 714, memories 716 and 718, and storage device 790) can store data and/or computer-executable instructions for executing an operating system 794 and application programs 796. Example data includes web pages, text messages, images, sound files, and video data to be sent to and/or received from one or more network servers or other devices by the system 700 via the one or more wired or wireless networks 786, or for use by the system 700. The system 700 can also have access to external memory or storage (not shown) such as external hard drives or cloud-based storage.

The operating system 794 can control the allocation and usage of the components illustrated in FIG. 7 and support the one or more application programs 796. The application programs 796 can include common computing system applications (e.g., email applications, calendars, contact managers, web browsers, messaging applications) as well as other computing applications.

The computing system 700 can support various additional input devices, such as a touchscreen, microphone, monoscopic camera, stereoscopic camera, trackball, touchpad, trackpad, proximity sensor, light sensor, electrocardiogram (ECG) sensor, PPG (photoplethysmogram) sensor, galvanic skin response sensor, and one or more output devices, such as one or more speakers or displays. Other possible input and output devices include piezoelectric and other haptic I/O devices. Any of the input or output devices can be internal to, external to, or removably attachable with the system 700. External input and output devices can communicate with the system 700 via wired or wireless connections.

In addition, the computing system 700 can provide one or more natural user interfaces (NUIs). For example, the operating system 794 or applications 796 can comprise speech recognition logic as part of a voice user interface that allows a user to operate the system 700 via voice commands. Further, the computing system 700 can comprise input devices and logic that allows a user to interact with computing the system 700 via body, hand or face gestures.

The system 700 can further include at least one input/output port comprising physical connectors (e.g., USB, IEEE 1394 (FireWire), Ethernet, RS-232), a power supply (e.g., battery), a global satellite navigation system (GNSS) receiver (e.g., GPS receiver); a gyroscope; an accelerometer; and/or a compass. A GNSS receiver can be coupled to a GNSS antenna. The computing system 700 can further comprise one or more additional antennas coupled to one or more additional receivers, transmitters, and/or transceivers to enable additional functions.

It is to be understood that FIG. 7 illustrates only one example computing system architecture. Computing systems based on alternative architectures can be used to implement technologies described herein. For example, instead of the processors 702 and 704 and the graphics engine 752 being located on discrete integrated circuits, a computing system can comprise an SoC (system-on-a-chip) integrated circuit incorporating multiple processors, a graphics engine, and additional components. Further, a computing system can connect its constituent component via bus or point-to-point configurations different from that shown in FIG. 7. Moreover, the illustrated components in FIG. 7 are not required or all-inclusive, as shown components can be removed and other components added in alternative embodiments.

As used herein, the term "module" refers to logic that may be implemented in a hardware component or device, software or firmware running on a processor unit, or a combination thereof, to perform one or more operations consistent with the present disclosure. Software and firmware may be embodied as instructions and/or data stored on non-transitory computer-readable storage media. As used herein, the term "circuitry" can comprise, singly or in any combination, non-programmable (hardwired) circuitry, programmable circuitry such as processor units, state machine circuitry, and/or firmware that stores instructions executable by programmable circuitry. Modules described herein may, collectively or individually, be embodied as circuitry that forms a part of a computing system. Thus, any of the modules can be implemented as circuitry. A computing system referred to as being programmed to perform a method can be programmed to perform the method via software, hardware, firmware, or combinations thereof.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of' can mean any combination of the listed terms. For example, the phrase "at least one of A, B or C" can mean A; B; C; A and B; A and C; B and C; or A, B, and C. Moreover, as used in this application and the claims, a list of items joined by the term "one or more of' can mean any combination of the listed terms. For example, the phrase "one or more of A, B and C" can mean A; B; C; A and B; A and C; B and C; or A, B, and C.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein.

Example 1 is an apparatus, comprising: an integrated circuit component comprising one or more integrated circuits; and a power interposer physically coupled to the integrated circuit component, the power interposer comprising: one or more voltage regulator module connections located on a first surface of the power interposer; and a plurality of socket connections located on a second surface of the power interposer, the first surface and the second surface facing opposite directions.

Example 2 comprises the apparatus of Example 1, wherein the integrated circuit component comprises a plurality of I/O signal connections, the power interposer to electrically connect the I/O signal connections to the socket connections.

Example 3 comprises the apparatus of Example 2, wherein the power interposer comprises a plurality of through-holes, the power interposer to electrically connect the I/O signal connections to the socket connections via the through-holes.

Example 4 comprises the apparatus of any one of Examples 1-3, wherein the integrated circuit component comprises a plurality of power signal connections, the power interposer to electrically connect the voltage regulator module connections to the power signal connections.

Example 5 is a system comprising: an integrated circuit component comprising one or more integrated circuits; a voltage regulator module to generate one or more regulated power signals based on one or more input power signals; and a power interposer physically coupled to the integrated circuit component and the voltage regulator module, the power interposer to electrically connect the regulated power signals to the integrated circuit component, the voltage regulator module physically coupled to the power interposer on a first surface of the power interposer, the power interposer comprising a plurality of socket connections located on a second surface of power interposer, the first surface of the power interposer and the second surface of the power interposer facing opposite directions.

Example 6 comprises the system of Example 5, wherein the integrated circuit component comprises a plurality of I/O signal connections, the power interposer to electrically connect the I/O signal connections to the socket connections.

Example 7 comprises the system of Example 6, wherein the power interposer comprises a plurality of through-holes, the power interposer to electrically connect the I/O signal connections to the socket connections via the through-holes.

Example 8 comprises the system of any one of Examples 5-7, wherein the integrated circuit component comprises a plurality of power signal connections, the power interposer electrically connecting the voltage regulator module to the power signal connections.

Example 9 comprises the system of any one of Examples 5-8, further comprising a power connector physically coupled to the voltage regulator module and a system board, the power connector to deliver one or more input power signals from the system board to the voltage regulator module.

Example 10 comprises the system of any one of Examples 5-9, wherein the power connector comprises one or more pins.

Example 11 comprises the system of any one of Examples 5-9, wherein the power connector comprises a cable connector.

Example 12 comprises the system of any one of Examples 5-11, wherein the voltage regulator module comprises a printed circuit board that is substantially parallel to the power interposer.

Example 13 comprises the system of any one of Examples 5-12, wherein the voltage regulator module is physically coupled to the power interposer via an interconnect socket.

Example 14 comprises the system of any one of Examples 5-13, wherein the interconnect socket is a dual compression socket.

Example 15 comprises the system of any one of Examples 5-14, further comprising: a system board comprising a plurality of system board connections; and a socket physically coupled to the system board, the socket to electrically connect the system board connections to the socket connections and physically couple the power interposer to the system board.

Example 16 comprises the system of any one of Examples 5-15, wherein the integrated circuit component comprises a plurality of power signal connections and a plurality of I/O signal connections, the socket and the power interposer to electrically connect the system board connections to the I/O signal connections, and the power interposer to electrically connect the power signal connections to the voltage regulator module.

Example 17 comprises the system of any one of Examples 5-16, further comprising a plurality of memory modules physically coupled to the system board and electrically connected to the integrated circuit component via the system board, the socket, and the power interposer.

Example 18 comprises the system of any one of Examples 5-15, wherein one of the system board connections is an input power signal, the socket and the power interposer to electrically connect the input power signal to the voltage regulator module.

Example 19 comprises the system of any one of Examples 5-18, further comprising one or more additional voltage regulator modules physically coupled to the power interposer to provide additional regulated power signals to the integrated circuit component.

Example 20 is a system comprising: an integrated circuit component comprising: one or more integrated circuits; a plurality of power signal connections; and a plurality of I/O signal connections; a voltage regulator module to generate one or more regulated power signals from one or more input power signals; a system board; and a signal delivery means to electrically connect the regulated power signals to the power signal connections and to electrically connect the I/O signal connections to the system board.

Example 21 comprises the system of Example 20, further comprising one or more additional voltage regulator modules to generate one or more additional regulated power signals, the signal delivery means to further electrically connect the one or more additional regulated power signals to the integrated circuit component.

Example 22 comprises the system of Example 20 or 21, further comprising a power connector physically coupled to the voltage regulator module and the system board, the power connector to deliver the one or more input power signals from the system board to the voltage regulator module.

Example 23 is a method, comprising: providing, via one or more power connectors, one or more input power signals from a system board to a voltage regulator module; generating, via the voltage regulator module, one or more regulated power signals based on the one or more input power signals; and providing, via a power interposer, the regulated one or more power signals to an integrated circuit component.

Example 24 comprises the method of Example 23, further comprising providing a plurality of I/O signals from the system board to the integrated circuit component via a socket and the power interposer.

Example 25 is an apparatus comprising one or more means to perform any one of the methods of Examples 23-24.

## Claims

1. An apparatus, comprising:
an integrated circuit component comprising one or more integrated circuits; and
a power interposer physically coupled to the integrated circuit component, the power interposer comprising:
one or more voltage regulator module connections located on a first surface of the power interposer; and
a plurality of socket connections located on a second surface of the power interposer, the first surface and the second surface facing opposite directions.

2. The apparatus of claim 1, wherein the integrated circuit component comprises a plurality of I/O signal connections, the power interposer to electrically connect the I/O signal connections to the socket connections.

3. The apparatus of claim 2, wherein the power interposer comprises a plurality of through-holes, the power interposer to electrically connect the I/O signal connections to the socket connections via the through-holes.

4. The apparatus of any one of claims 1-3, wherein the integrated circuit component comprises a plurality of power signal connections, the power interposer to electrically connect the voltage regulator module connections to the power signal connections.

5. A system comprising:
an integrated circuit component comprising one or more integrated circuits;
a voltage regulator module to generate one or more regulated power signals based on one or more input power signals; and
a power interposer physically coupled to the integrated circuit component and the voltage regulator module, the power interposer to electrically connect the regulated power signals to the integrated circuit component, the voltage regulator module physically coupled to the power interposer on a first surface of the power interposer, the power interposer comprising a plurality of socket connections located on a second surface of power interposer, the first surface of the power interposer and the second surface of the power interposer facing opposite directions.

6. The system of claim 5, wherein the integrated circuit component comprises a plurality of I/O signal connections, the power interposer to electrically connect the I/O signal connections to the socket connections.

7. The system of claim 6, wherein the power interposer comprises a plurality of through-holes, the power interposer to electrically connect the I/O signal connections to the socket connections via the through-holes.

8. The system of any one of claims 5-7, wherein the integrated circuit component comprises a plurality of power signal connections, the power interposer electrically connecting the voltage regulator module to the power signal connections.

9. The system of any one of claims 5-8, further comprising a power connector physically coupled to the voltage regulator module and a system board, the power connector to deliver one or more input power signals from the system board to the voltage regulator module.

10. The system of any one of claims 5-9, wherein the voltage regulator module comprises a printed circuit board that is substantially parallel to the power interposer.

11. The system of any one of claims 5-10, further comprising:
a system board comprising a plurality of system board connections; and
a socket physically coupled to the system board, the socket to electrically connect the system board connections to the socket connections and physically couple the power interposer to the system board.

12. The system of claim 11, wherein the integrated circuit component comprises a plurality of power signal connections and a plurality of I/O signal connections, the socket and the power interposer to electrically connect the system board connections to the I/O signal connections, and the power interposer to electrically connect the power signal connections to the voltage regulator module.

13. The system of claim 11 or 12, further comprising a plurality of memory modules physically coupled to the system board and electrically connected to the integrated circuit component via the system board, the socket, and the power interposer.

14. The system of any one of claims 11-13, wherein one of the system board connections is an input power signal, the socket and the power interposer to electrically connect the input power signal to the voltage regulator module.

15. The system of any one of claims 11-14, further comprising one or more additional voltage regulator modules physically coupled to the power interposer to provide additional regulated power signals to the integrated circuit component.
